# EUROPÄISCHE PATENTSCHRIFT

(11) **EP 1 190 801 B1**
(45) Veröffentlichungstag und Bekanntmachung des Hinweises auf die Patenterteilung: **07.04.2004**
(21) Anmeldenummer: 01121993.8
(22) Anmeldetag: 13.09.2001
(51) Int. Cl.: B23K 3/06

(54) **Vorrichtung zum Aufbringen von Lotpaste auf eine Leiterplatte an mehreren Punkten**
Apparatus for multi-point deposition of solder paste on a printed circuit board
Appareil pour la déposition multi-ponctuelle de pâte à souder sur une plaquette de circuit imprimé

(30) Priorität: 14.09.2000 DE 10045359
(43) Veröffentlichungstag der Anmeldung: 27.03.2002
(73) Patentinhaber: Hecht, Gerald, 89584 Ehingen (DE)
(72) Erfinder: Hecht, Gerald, 89584 Ehingen (DE)
(74) Vertreter: Weber, Gerhard, Dipl.-Phys.

(56) Entgegenhaltungen:
- DE-A- 19 838 532
- US-A- 5 497 938
- US-A- 5 655 704
- US-A- 5 938 106
- US-A- 5 947 022
- US-A- 6 056 190

## Beschreibung

Die Erfindung betrifft eine Vorrichtung zum Aufbringen von Lotpaste auf eine Leiterplatte.

Insbesondere für die Herstellung von mit Bauelementen bestückten Leiterplatten nach Reflow-Verfahren ist es bekannt, Leiterplatten mit vorgegebenen Leiterbahnenmuster an Positionen, wo elektrische Kontakte mit Bauelementanschlüssen vorgesehen sind, mit geringen Mengen von Lotpaste zu versehen, die Bauelemente in die vorbestimmten Positionen auf der mit Lotpaste versehenen Leiterplatte zu bringen und in einem Reflow-Ofen die Lotpaste aufzuschmelzen, wobei sich über erstarrten Lotkontakte sowohl die elektrische Kontaktierung als auch die mechanische Fixierung der Bauelemente ergibt. Die Haftung der Bauelemente, insbesondere SMT-Bauelemente, in den vorbestimmten Positionen vor dem Reflow-Prozess kann sowohl über die auf die Lotpaste aufgedrückten Kontakte als auch über zusätzliche Kleberpunkte erfolgen.

Die Lotpaste in dem gewünschten Muster wird herkömmlicherweise insbesondere durch ein Siebdruckverfahren aufgebracht, wie beispielsweise in der EP 0 478 170 B1 als Stand der Technik angegeben. Das Siebdruckverfahren ist vor allem für geringe Stückzahlen von Leiterplatten mit identischen Lotpastenmuster aufwendig, da für jedes Muster jeweils eine eigene Maske angefertigt werden muß. Der indirekte Einsatz eines Siebdruckverfahrens ist aus der EP 0 570 716 B1 bekannt, um in einer Graphitplatte mit einem regelmäßigen Raster von Sacklöchern einen Teil der Löcher abzudecken, wogegen die nicht abgedeckten Löcher ein zum vorgesehenen Lotpastenmuster spiegelbildliches Muster bilden und mit Lotpaste gefüllt werden. Die Platte wird mit nach unten weisenden Sacklochöffnungen auf die Leiterplatte aufgesetzt und erhitzt, wobei die Lotpaste schmilzt und als Lot in genau definierten Mengen auf die Leiterplatte fällt.

In der EP 0 478 170 B1 ist eine in zwei orthogonalen Richtungen relativ zur Leiterplatte verschiebbare Düse beschrieben, welche Lot aufschmilzt und als Lotspur auf lineare Arrays von Kontaktpunkten aufbringt.

Die EP 0 423 184 B1 beschreibt gleichfalls eine zweiachsig verfahrbare Düse, bei welcher eine Lotpastenkammer, deren Volumen durch piezoelektrisch verschiebbare Seitenwände variierbar ist, periodisch in einem ersten Schritt bei aufgeweitetem Volumen mit Lotpaste gefüllt und zur Vorratsseite geschlossen und in einem zweiten Schritt zum Düsenausgang geöffnet und im Volumen reduziert wird, wobei ein Lotpastentropfen aus der Düse auf die Leiterplatte ausgestoßen wird. Düsenanordnungen zum Aufbringen von Lotpaste sind auch aus der DE 39 35 709 A1 und der DE 37 28 054 C2 bekannt.

Bei einer aus der DE 39 07 681 A1 bekannten Vorrichtung zum Beschichten der Köpfe von gegurteten Kopfdrähten wird aus einem Lotband ein der Drahtkopfarm angepaßter Formteil ausgestanzt, auf dem Drahtkopf abgelegt und nachfolgend aufgeschmolzen.

Die Vorrichtungen mit zweiachsig steuerbaren Düsen sind zwar flexibel, es zeigt sich aber, daß die genaue Mengendosierung und die Formgebung der Lotpastenpunkte stark variiert und unzureichend reproduzierbar ist, so daß keine zuverlässig feinen Strukturen erzielbar sind. Für Leiterplatten mit sehr vielen Lotpastenpunkten bzw. -flächen ist zudem die Geschwindigkeit dieser Vorrichtung unbefriedigend.

Die US 6 056 190 A beschreibt eine Vorrichtung, mit welcher auf einem Halbleitersubstrat ein Array von Lotkugeln in einem gewünschten Muster platziert werden kann. Ein Träger mit einem regelmäßigen Raster von Durchgangslöschern durchläuft eine Mehrzahl von Arbeitsstationen, in welchem u..a die Löcher mit je einer Lotkugel bestückt werden. An der letzten Arbeitsstation ist der Träger relativ zu einem Druckkopf mit einem festen Raster von Stiften so ausgerichtet, dass das Stiftraster vollständig deckungsgleich zu dem Lochraster ausgerichtet ist und in einem Übertragungsvorgang alle Lotkugeln aus dem Lochraster ausgedrückt und auf das unter dem Träger befindliche Halbleitersubstrat als das gewünschte Muster übertragen werden. Für ein bestimmtes Muster können in einer Ausführung das Lochraster des Trägers und der das Stiftraster des Druckkopfs übereinstimmend dieses Muster darstellen, wodurch aber für jedes Muster ein eigener Druckkopf und ein eigener Satz von Trägern benötigt wird. Bevorzugt ist daher eine Ausführung, bei welcher Lochraster und Stiftraster übereinstimmend ein allgemein verwendbares regelmäßiges Raster bilden und in einer vor dem Druckkopf liegenden Arbeitsstation ein Negativ-Druckkopf mit zu dem gewünschten Muster negativen Raster an Stiften, die für das gewünschte Muster nicht benötigten Plätze des Lochrasters von Kugeln befreit. An der letzten Arbeitsstation kann ein Magazin mit einer Mehrzahl von Halbleitersubstraten in regelmäßiger Anordnung vorgesehen sein, welches auf einem x-y-Tisch verfahrbar ist, um in aufeinanderfolgenden Arbeitstakten jeweils ein neues Substrat unter dem Druckkopf und einen in jedem Arbeitstakt neu in die letzte Arbeitsstation übernommenen Träger zu positionieren.

Die US 5 497 938 A beschreibt die Übertragung von Lotkugeln von einem Band auf ein Halbleitersubstrat, wobei in einer Ausführungsform das Band periodisch wiederholt gleiche Lochraster in dem bei der Übertragung zu erzeugenden Muster aufweist und in den Löchern des Rasters gehaltene Lotkugeln mittels eines Druckkopfes mit einem Stiftraster aus den Löchern ausgedrückt und nachfolgend auf ein Substrat übertragen werden, wobei Lochraster und Stiftraster miteinander und mit dem gewünschten Muster übereinstimmen und alle Lotkugeln des Musters in einem Druckvorgang auf das Substrat übertragen werden. Ein Karussellmagazin positioniert das nächste Substrat für die nächste Übertragung desselben Musters über den Druckkopf und durch Weiterbewegen des Bandes wird ein neues gefülltes Lochraster zwischen Druckkopf und Substrat gerückt.

Der Erfindung liegt die Aufgabe zugrunde, eine Vorrichtung zum Aufbringen von Lotpaste auf eine Leiterplatte anzugeben, welche sich durch große Flexibilität und hohe Genauigkeit des erzielbaren Lotpastenmusters auszeichnet.

Die Erfindung ist im Patentanspruch 1 beschrieben. Die abhängigen Ansprüche enthalten vorteilhafte Ausgestaltungen und Weiterbildungen der Erfindung.

Erfindungsgemäß ist die Vorrichtung zum Aufbringen von Lotpaste auf Leiterplatten mittels einer relativ zur Leiterplatte verfahrbaren Transfereinrichtung, welche durch eine Mehrzahl zeitlich aufeinanderfolgenden Übertragungsvorgängen ein vorgebbares Pastenmuster auf der Leiterplatte erzeugt, dadurch gekennzeichnet, daß die Transfereinrichtung einen Pastenträger mit einer Mehrzahl von mit Lötpaste gefüllten Pastenkammern und einen Druckkopf zur Übertragung der Lötpaste aus auswählbaren Pastenkammern auf die Leiterplatte umfaßt.

Eine vorteilhafte Ausführungsform sieht vor, daß die Übertragung der Lötpaste aus einer Pastenkammer auf die Leiterplatte mittels eines senkrecht zur Leiterplatte durch die Pastenkammer verschiebbaren Transferelements erfolgt.Das Transferelement weist dabei günstigerweise im Querschnitt ein geringes Untermaß gegen den Querschnitt der Pastenkammer auf. Vorteilhafterweise besitzt das Transferelement einen der Leiterplatte zugewandten drahtförmigen Abschnitt.

Gemäß einer ersten vorteilhaften Ausführung kann vorgesehen sein, daß der Druckkopf und der Pastenträger relativ zueinander fixiert sind und der Druckkopf zu jeder auswählbaren Pastenkammer ein einzeln betätigbares Transferelement aufweist. Eine andere Ausführung sieht vor, daß der Pastenträger relativ zum Druckkopf bewegbar ist und die Zahl der Transferelemente klein ist gegen die Zahl der Pastenkammern.

Vorzeugsweise sind mehrere Transferelemente in einer quer zur Bewegungsrichtung des Pastenträgers verlaufenden Reihe angeordnet, wobei vorteilhafterweise der Druckkopf in Bewegungsrichtung beabstandet und quer dazu mit Lückenversatz der Transferelemente mehrere Elementreihen aufweisen kann. Die Pastenkammern bilden vorteilhafterweise ein in Bewegungsrichtung des Pastenträgers periodisch wiederholtes Muster.

Eine vorteilhafte Ausführungsform sieht vor, daß der Pastenträger und der Druckkopf korrespondierende Ausrichtelemente aufweisen, welche eine Positionszuordnung des Druckkopfs zu der Periode des Musters der Pastenkammern ermöglichen.

Die Bewegung des Pastenträgers kann vorteilhafterweise schrittweise erfolgen und für einen Übertragungsvorgang unterbrochen sein. In anderer Ausführung kann vorgesehen sein, daß die Bewegung des Pastenträgers kontinuierlich erfolgt und die dem Pastenträger zugewandten Enden der Transferelemente zumindest während des Übertragungsvorgang in Bewegungsrichtung gleichförmig mit dem Pastenträger mitlaufen. Dabei kann vorgesehen sein, daß die Transferelemente auf einem rotierenden walzenförmigen Elementträger angeordnet sind, und/oder daß wenigstens die dem Pastenträger zugewandten Abschnitte der Transferelemente auf einem in Bewegungsrichtung des Pastenträgers oszielierenden Schwingträgers angeordnet sind, welcher während eines Übertragungsvorgangs gleichsinnig und zwischen aufeinanderfolgenden Übertragungsvorgängen gegensinnig zu dem Pastenträger bewegt ist. Die dem Pastenträger zugewandten Enden der Transferelemente in Bewegungsrichtung des Pastenträgers sind vorteilhafterweise elastisch verformbar.

Der Pastenträger ist vorzugsweise flach mit einer gegen die Querabmessung sehr geringen Dicke ausgeführt ist. Insbesondere kann vorteilhafterweise vorgesehen sein, daß das Verhältnis der Dicke des Pastenträgers zu dem Durchmesser der Pastenkammern in einem Bereich zwischen 0,6 und 3,0, insbesondere zwischen 1,0 und 2,0 liegt, und/oder daß die Dicke des Pastenträgers zwischen 0,1 mm und 0,8 mm liegt.

Gemäß einer bevorzugten Ausführungsform ist vorgesehen, daß der Pastenträger als um eine Drehachse kreissymmetrischer Ringmantel von einer Trägerscheibe absteht. In anderer Ausführung ist vorgesehen, daß der Pastenträger ein flexibles Band, insbesondere ein endloses Ringband oder ein gewikkeltes Band ist, wobei vorteilhafterweise das flexible Band im aufgewickelten Ausgangszustand gefüllte Pastenkammern aufweist. Das flexible Band kann vorteilhafterweise quer zur Bewegungsrichtung zumindest im Bereich des Druckkopfs präzis geführt sein.

Vorteilhafterweise umfasst die Vorrichtung eine Füllvorrichtung zur Befüllung von leeren Pastenkammern.

Der Pastenträger besteht vorzugsweise aus Metall, insbesondere aus Edelstahl.

Vorteilhafterweise kann vorgesehen sein, daß die Transfereinrichtung in mehreren in einer ersten Verfahrrichtung (X) nebeneinander liegenden, in einer dazu senkrechten zweiten Verfahrrichtung (Y) laufenden Bahnen relativ zur Leiterplatte verfahrbar ist, insbesondere, daß die relative Verfahrbarkeit in der zweiten Verfahrrichtung (Y) durch Transport der Leiterplatte und die relative Verfahrbarkeit in der ersten Verfahrrichtung (X) durch Verschiebung der Transfereinrichtung realisiert ist und/oder daß die Bewegungsrichtung eines beweglichen Pastenträgers in der Transfereinrichtung parallel zur ersten Verfahrrichtung verläuft.

Mit einem Transferelement kann ein Hilfselement verschiebbar sein, wobei die Verschiebung des Transferelements durch Anschlag des Hilfselements auf der Leiterplatte begrenzt ist. Dabei kann günstigerweise das Hilfselement seitlich vom Pastenträger vorbeigeführt sein.

Das Volumen der in den Pastenkammern des Pastenträgers jeweils bereit gehaltenen Lotpastenmenge kann gleichbleibend präzise vorgegeben werden, so daß stets eine definierte Menge von Lotpaste aus einer Pastenkammer auf die Leiterplatte übertragen wird. Der Übertragungsvorgang mittels eines Druckkopfes kann an sich auf unterschiedliche Weise erfolgen. Bevorzugt wird jedoch eine mechanische Verschiebung des Pastenvolumens aus der Kammer auf die Leiterplatte mittels eines senkrecht zur Leiterplattenfläche verschiebbaren Transferelements, welches von der der Leiterplatte abgewandten Seite der Pastenkammer in diese eintaucht und die Paste im wesentlichen ohne deren Form zu ändern aus der Kammer ausstößt. Vorzugsweise ist die Endposition des Transferelements so eingestellt, daß die Paste als im wesentlichen zylindrischer Pfropf noch auf die Leiterplatte aufgedrückt und dabei u. U. auch leicht abgeflacht wird, ohne jedoch die durch den Querschnitt von Pastenkammer bzw. Transferelement gegebene Form insbesondere in der Projektion auf die Leiterplatte wesentlich zu verändern.

Die Endposition des Transferelements kann insbesondere durch ein mit dem Transferelement mitbewegtes Anschlagelement gegeben sein, welches an eine Gegenfläche im Druckkopf oder in anderer Ausführung durch gesonderte Öffnungen des Pastenträgers oder seitlich an diesem vorbeigeführt auf der Leiterplatte als Gegenfläche anschlagen kann.

Das Transferelement kann dabei ähnlich den Nadeln von Nadeldruckern zumindest über einen der Leiterplatte zugewandten Abschnitt drahtförmig ausgebildet und im Druckkopf gleitend geführt sein. Für die Betätigung solcher Nadeln als Transferelemente mittels elektrisch erregter Spulen kann vorteilhafterweise auf die von Nadeldruckern bekannten Techniken zumindest teilweise zurückgegriffen werden. Die Transferelemente sind an ihrer der Leiterplatte zugewandten Stirnfläche vorzugsweise eben oder konkav gewölbt und zeigen im Querschnitt ein geringes Untermaß gegen den Querschnitt der Pastenkammern. Die Kante der Stirnfläche kann leicht angefast sein, wodurch das Eintauchen des Transferelements in die Pastenkammer erleichtert werden kann. Die radiale Erstreckung der Fase beträgt vorzugsweise weniger als 10 % des Durchmessers der Stirnfläche.

Die Transferelemente können im Druckkopf so angeordnet und geführt sein, daß ihr gegenseitiger Abstand an den Eingängen der Pastenkammern gering ist, auch wenn die individuelle Betätigung der einzelnen Elemente in einem dem Pastenträger fernen Bereich des Druckkopfs wesentlich mehr Platz beansprucht. Auch hierzu kann auf konstruktive Details aus der Technologie der Nadeldrucker verwiesen werden, welche teilweise in gleicher oder ähnlicher Form auch bei der erfindungsgemäßen Vorrichtung realisierbar sind. Insbesondere können die Endbereiche der Transferelemente in gekrümmten Führungen des Druckkopfes oder die Betätigungselemente in gekrümmten Führungen einer Betätigungseinrichtung geführt sein.

Die Transferelemente können gemäß einer vorteilhaften Ausführungsform zwischen der Führung im Druckkopf und dem Pastenträger einen freiliegenden Abschnitt mit im wesentlichen konstantem Querschnitt aufweisen, wobei die Länge dieses Abschnitts vorzugsweise ein Mehrfaches der Dicke des Pastenträgers beträgt. Durch die dabei gegebene laterale Beweglichkeit der Endabschnitte der Transferelemente kann die Gefahr des Verkantens von Transferelementen in den Pastenkammern gemindert werden.

Das Vorliegen mehrerer Transferelemente in einem Druckkopf kann den Vorgang des Aufbringens von Lotpaste erheblich beschleunigen, indem mehrere Übertragungsvorgänge mittels verschiedener Transferelemente gleichzeitig ausgelöst werden können. Die Anordnung mehrerer Transferelemente in einem Druckkopf ist auf das Raster der Pastenkammern im Pastenträger abgestimmt.

In einer ersten Ausführungsform sind Druckkopf und Pastenträger relativ zueinander fixiert und jeder Pastenkammer ist ein eigenes individuell betätigbares Transferelement zugeordnet. Der Pastenträger kann dabei insbesondere walzenförmig sein.

Vorzugsweise sind aber Pastenträger und Druckkopf relativ zueinander bewegbar und die Zahl der Transferelemente ist klein gegen die Zahl der Pastenkammern. Vorzugsweise ist die Anordnung der Pastenkammern im Pastenträger in Richtung der Relativbewegung des Pastenträgers gegen den Druckkopf periodisch wiederholt und innerhalb einer Periode auf die Anordnung der mehreren Transferelemente im Druckkopf abgestimmt.

Mehrere Transferelemente in einem Druckkopf können insbesondere in einer oder mehreren quer zur Bewegungsrichtung des Pastenträges verlaufenden Elementreihe angeordnet sein, wobei bei mehreren Reihen, welche in Bewegungsrichtung des Pastenträgers beabstandet sind, der besondere Vorteil besteht, daß die Transferelemente verschiedener Reihen quer zur Bewegungsrichtung relativ zueinander versetzt sind und die bei einer Reihe notwendigerweise verbleibenden Lücken zwischen benachbarten Elementen durch die Elemente der anderen Reihen überbrückt bzw. geschlossen werden können.

Da ein Transferelement nur betätigt werden darf, wenn in dessen Verschieberichtung eine Pastenkammer liegt und dies bei relativ zum Druckkopf bewegten Pastenträger nur zu bestimmten Zeitpunkten bzw. bestimmten Relativpositionen gegeben ist, ist die Betätigung von Transferelementen mit der Bewegung des Pastenträgers relativ zum Druckkopf zu synchronisieren. Vorteilhafterweise können hierzu an Pastenträger und an Druckkopf korrespondierende Ausrichtelemente vorhanden sein, beispielsweise zusätzliche Indexdurchbrüche im Pastenträger und optische, mechanische, magnetische etc. Sensoren am Druckkopf. Gemäß einer alternativen Ausführung, insbesondere mit einem Pastenträger, der als Ring von einer Trägerplatte absteht, können die Drehpositionen der Trägerplatte detektiert und/oder bei schrittweiser Fortschaltung die Druckzeitpunkte aus dem Schritttakt der Fortschaltung abgeleitet sein.

Die Bewegung des Pastenträgers relativ zum Druckkopf kann gemäß einer ersten Ausführung schrittweise in der Art erfolgen, daß die Bewegung bei übereinstimmenden Positionen von Transferelementen und Pastenkammern für einen Übertragungsvorgang angehalten wird und nach dem Übertragungsvorgang der Pastenträger einen Schritt weiter transportiert wird.

Gemäß einer anderen vorteilhaften Ausführungsform wird der Pastenträger quasi kontinuierlich bewegt und die dem Pastenträger zugewandten Enden der Transferelemente werden während des Übertragungsvorgangs gleichförmig, d. h. in gleicher Richtung und zumindest annähernd gleicher Geschwindigkeit wie der Pastenträger verschoben und laufen dadurch mit den kontinuierlich weiterbewegten Pastenkammern zumindest während des Übertragungsvorgangs mit. Dies kann beispielsweise erreicht werden mittels einer rotierenden trommelförmigen Anordnung von Transferelementen, welche über einen kurzen Trommelabschnitt an dem Pastenträger anliegen oder diesem dicht gegenüberstehen. Eine andere Realisierungsform kann vorsehen, daß der Druckkopf oder zumindest ein Führungsblock für die Enden der Transferelemente in Bewegungsrichtung des Pastenträgers eine oszillierende Bewegung ausführt, wobei in der mit dem Pastenträger gleichsinnigen Bewegungsphase ein Übertragungsvorgang vorgenommen werden kann und zwischen zwei aufeinanderfolgenden Übertragungsvorgängen mit in den Druckkopf zurückgezogenen Transferelementen die gegensinnige Bewegungsphase abläuft.

Gemäß einer vorteilhaften Weiterbildung kann vorgesehen sein, dass während des Andrucks der mittels eines Transferelements aus einer Pastenkammer ausgedrückten Lotpaste auf die Leiterplatte eine zusätzliche Relativbewegung zwischen Transferelement und Leiterplatte parallel zur Leiterplattenebene erfolgt, wobei die Amplitude dieser zusätzlichen Relativbewegung vorzugsweise kleiner ist als das 0,2-fache des Pastenkammerdurchmessers. Diese zusätzliche Relativbewegung führt günstigerweise zu einer verbesserten Haftung der Lotpaste auf der Leiterplatte. Die Relativbewegung erfolgt vorteilhafterweise in zwei orthogonalen Richtungen der Plattenebene und kann beispielsweise eine kreisbewegung o.ä. sein. Die zusätzliche Relativbewegung kann beispielsweise durch auf Druckkopf bzw. Transferelement und/oder auf die Leiterplatte wirkende Vibrationselemente erfolgen. Eine bevorzugte Ausführungsform sieht vor, daß die ohnehin für die relative Verschiebung von Leiterplatte und Druckkopf vorgesehenen Antriebseinrichtungen zusätzlich mit Signalen zur Ausführung der zusätzlichen Relativbewegung beaufschlagt sind. Insbesondere kann bei Einsatz von Schrittmotoren zur relativen Verschiebung von Druckkopf und Leiterplatte vorgesehen sein, dass der einem Schrittimpuls entsprechende Verschiebungsweg klein ist gegen den Durchmesser einer Pastenkammer und damit gegen den Durchmesser eines ausgestossenen Pastenkörpers und dass die zusätzliche Relativbewegung durch zusätzliche Schrittimpulse an die Antriebseinrichtungen ausgelöst wird. Vorzugsweise erfolgt die zusätzliche Relativbewegung so schnell, dass während des Andrucks eines ausgestossenen Patenkörpers an die Leiterplatte durch das Transferelement mehrere Hin- und Herbewegungen der zusätzlichen Relativbewegung stattfinden.

Die Erfindung ist nachfolgend anhand von bevorzugten Ausführungsbeispielen unter Bezugnahme auf die Abbildungen noch eingehend veranschaulicht. Dabei zeigt
- Fig. 1: eine erste Ausführungsform der Erfindung
- Fig. 2: einen Querschnitt durch Fig. 1
- Fig. 3: einen Übertragungsvorgang im Transferbereich
- Fig. 4: eine Ausführungsform mit schrägstehender Drehachse
- Fig. 5: eine Ausführungsform mit einem flexiblen Endlosband
- Fig. 6: eine Ausführungsform nach Fig. 1 mit walzenförmigem Druckkopf
- Fig. 7: einen Ausschnitt aus Fig. 6 mit einem Transferbereich
- Fig. 8: eine Ausführungsform mit gewickeltem Band
- Fig. 9: einen oszillierenden Druckkopf
- Fig. 10: eine Draufsicht auf einen Pastenträger
- Fig. 11: Transferelemente mit langem Endabschnitt
- Fig. 12: eine spezielle Endlagenbegrenzung eines Transferelements
- Fig. 13: eine Anordnung mit Anschlagelementen außerhalb des Pastenträgers
- Fig. 14: eine Draufsicht zu Fig. 13
- Fig. 15: eine zusätzliche oszillierende Relativbewegung

Die Abbildungen zeigen lediglich die zur Erläuterung der Erfindung wesentlichen Teile der Vorrichtung und sind im Regelfall nicht als maßstabstreu zu verstehen. Die nicht mit eingezeichneten Elemente wie Wellenlager, Führungsschlitten, Befestigungselemente sind dem Fachmann in vielfacher Form geläufig.

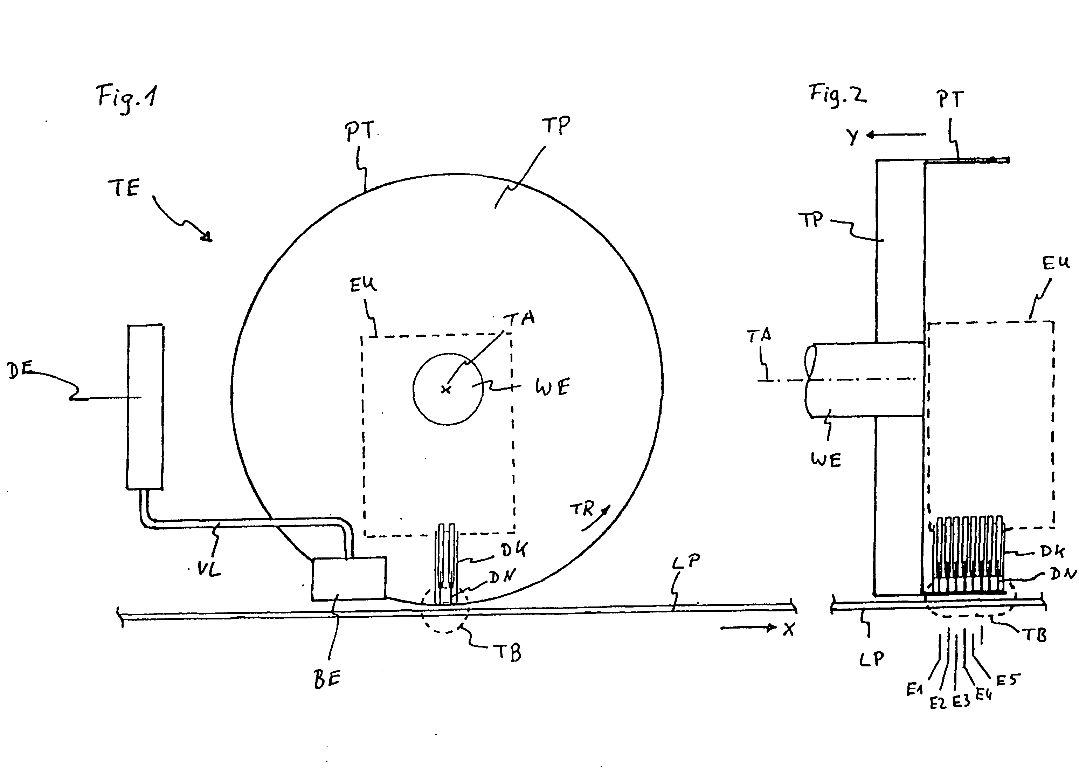

Bei der in Fig. 1 skizzierten Vorrichtung ist eine Leiterplatte LP auf einen nicht eingezeichneten Träger relativ zu einer Transfereinrichtung TE wenigstens in eine Verfahrrichtung X verfahrbar. Günstigerweise kann die Verfahrrichtung X mit einer im Herstellungsprozess der Leiterplatte vorgegebenen Transportrichtung zusammenfallen. Die Leiterplatte kann für den Vorgang des Aufbringens eines vorgegebenen Musters von Lotpastenpunkten von der Transfereinrichtung auf die Leiterplatte bidirektional parallel zu X verfahrbar sein, wodurch in Verbindung mit einer zusätzlichen relativen Verfahrbarkeit von Transfereinrichtung TE und Leiterplatte LP in einer zweiten Verfahrrichtung Y senkrecht zur Zeichenebene der Fig. 1 auf vorteilhafte Weise die Fläche der Leiterplatte in parallelen Bahnen überstrichen werden kann. Grundsätzlich kommt für jede Verfahrrichtung X, Y sowohl eine Verfahrung der Leiterplatte LP als auch der Transfereinrichtung TE in Betracht. Bevorzugt wird die Leiterplatte LP quasi kontinuierlich in der ersten (X) und die Transfereinrichtung schrittweise in der zweiten (Y) Richtung verfahrbar ausgebildet.

Die Transfereinheit TE enthält als wesentliche Elemente einen Pastenträger PT und einen Druckkopf DK, wobei in einem Transferbereich TB der Pastenträger PT zwischen Druckkopf DK und Leiterplatte LP liegt und im wesentlichen parallel zur Fläche der Leiterplatte und gering von dieser beabstandet verläuft.

In der in Fig. 1 skizzierten Ausführungsform ist der Pastenträger als Kreisring um eine Trägerachse TA ausgeführt und steht in Richtung parallel zur Trägerachse von einer mechanisch stabilen kreisrunden Trägerplatte TP ab (Fig. 2), welche mittels einer angetriebenen Welle WE um die Trägerachse TA drehbar ist. Die Drehung der Trägerplatte TP mit dem Pastenträger PT erfolgt vorzugsweise nur in einem Drehsinn, im skizzierten Beispiel in Drehrichtung TR im Gegenuhrzeigersinn.

Der Pastenträger PT hat eine über den Umfang und in achsialer Richtung konstante Wandstärke TW und kann beispielsweise durch Ausdrehen einstückig mit der Trägerplatte hergestellt oder als Ring auf der Trägerplatte befestigt sein. Der Pastenträger ist mit einer Vielzahl regelmäßig angeordneter Durchbrüche versehen, welche insbesondere in senkrecht zur Trägerachse TA verlaufenden Ebenen E1, E2, E3,... angeordnet sein können. Die Durchbrüche bilden Pastenkammern zur Aufnahme von Lotpaste.

Ein Druckkopf DK weist eine Mehrzahl von Drucknadeln DN als Transferelemente auf, welche im skizzierten Beispiel auf zwei parallele Nadelreihen verteilt sind und innerhalb einer Reihe jeweils in Y-Richtung mit konstantem Nadelabstand aufeinanderfolgen. Die beiden Nadelreihen sind in Bewegungsrichtung TR des Pastenträgers PT relativ zum Druckkopf beabstandet und die Nadelpositionen der beiden Reihen sind in Y-Richtung gegeneinander um einen halben Nadelabstand versetzt, so daß die Nadeln der beiden Reihen in Y-Richtung auf Lücke zueinander stehen. Die Nadeln liegen abwechselnd in den Ebenen E1, E3, E5, ... für die erste Nadelreihe bzw. E2, E4, E6, ... für die zweite Nadelreihe und damit in denselben Ebenen wie die Pastenkammern.

Die Drucknadeln DN sind senkrecht zur Ebene der Leiterplatte verschiebbar im Druckkopf geführt. Die Verschiebung kann beispielsweise in zur Nadeldruckertechnik analoger Weise mittels elektromagnetisch betätigter Stempel erfolgen. Eine derartige Betätigungseinrichtung EU ist mit unterbrochener Linie angedeutet. Der Aufbau einer solchen Betätigungseinrichtung im Detail ist an sich bekannt und für den Erfindungsgedanken ohne weitere Bedeutung. Eine solche Betätigungseinrichtung erlaubt nach Maßgabe einer Steuereinrichtung eine zeitlich genau vorgebbare Verschiebung einer oder mehrerer Drucknadeln, wenn sich Pastenkammern in Verschieberichtung der Drucknadeln befinden.

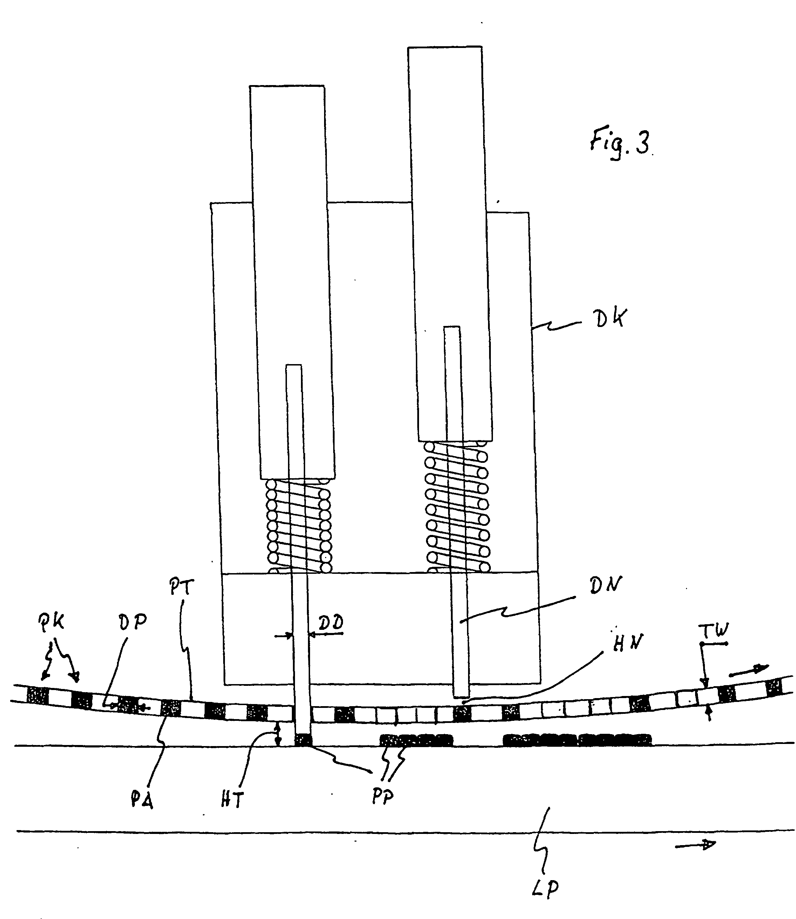

Bei Verschiebung einer Drucknadel DN durch eine Pastenkammer PK in Richtung der Leiterplatte LP (Fig. 3) wird die in der Kammer befindliche Lotpaste PA durch die Drucknadel, deren Querschnitt DD ein geringes Untermaß gegen den lichten Querschnitt DK der Pastenkammern PK zeigt, aus der Kammer ausgedrückt und durch die Stirnfläche der Drucknadel auf die Leiterplatte LP übertragen. Die Lotpaste behält bei diesem Übertragungsvorgang weitgehend die ursprüngliche zylindrische Tropfenform aus der Pastenkammer, so daß ein nach Menge und Form mit guter Reproduzierbarkeit definierter Lotpastenpunkt PP auf der Leiterplatte erzeugbar ist.

Der Durchmesser DK der Pastenkammern liegt vorzugsweise im Bereich von 0,1 - 0,5 mm. Die Wandstärke TW des Pastenträgers liegt typischerweise ebenfalls in einem solchen Bereich. Vorzugsweise liegt das Verhältnis TW/DK in einem Bereich zwischen 0,6 und 3,0, insbesondere zwischen 1,0 und 2,0. Der Abstand HT des Pastenträgers von der Leiterplatte ist geringfügig größer als die Wandstärke TW, um sicherzustellen, daß die ausgestoßene Lotpaste vollständig von der Pastenkammer gelöst ist. Ein geringer Abstand HN der Stirnfläche SF der Drucknadeln vom Pastenträger in der Ausgangsstellung der Drucknadeln verhindert auch bei unvermeidbaren Fertigungstoleranzen ein Schleifen der Drucknadeln an dem vorbei bewegten Pastenträger. Die Dauer eines Übertragungsvorgangs bis zur Rückführung der Drucknadel in die Ausgangsposition liegt typischerweise in der Größenordnung von einigen 10 bis 100 Millisekunden.

Die Rückholung der Drucknadeln in die Ausgangsposition kann z. B. in an sich bekannter Weise durch eine Rückholfeder oder wie die Verschiebung zur Leiterplatte hin durch eine Magnetgegenspule erfolgen. Entsprechende Techniken sind aus dem Bereich der Nadeldrucker bekannt.

Die Verschiebung der Drucknadel zur Übertragung der Lotpaste aus der Pastenkammer auf die Leiterplatte kann vorzugsweise durch einen mechanischen Anschlag begrenzt sein. Der Anschlag kann vorteilhafterweise so eingestellt sein, daß in der Endstellung der Drucknadel der aus der Pastenkammer ausgestoßene Lotpastenpfropf auf der Leiterplatte leicht flachgedrückt wird. Der Anschlag kann beispielsweise im Druckkopf realisiert sein. In anderer Ausführungsform kann der Anschlag durch ein mit der Drucknadel verschobenes Hilfselement realisiert sein, welches durch zusätzliche Öffnungen im Pastenträger hindurch auf der Leiterplatte anschlägt. Die Verschiebung kann derart begrenzt sein, daß in der maximalen Verschiebung der Drucknadel deren Stirnfläche zwar vollständig durch die Pastenkammer hindurchgetreten ist, aber noch einen größeren Abstand zur Leiterplatte aufweist als der Dicke TW der Lotpaste entspricht. Die Lotpaste wird dann gelöst von der Stirnfläche der Drucknadel über eine Restdistanz auf die Leiterplatte geschleudert. In anderer Ausführungsform wird die Drucknadel so weit verschoben, daß die aus der Pastenkammer ausgedrückte Lotpaste von der Stirnfläche der Drucknadel auf die Leiterplatte gedrückt wird. Der dabei auftretende Gegendruck kann u. U. auch einen mechanischen Anschlag im Druckkopf für die Verschiebung der Drucknadel entbehrlich machen.

Die Pastenkammern weisen vorzugsweise einen kreisrunden Querschnitt auf und können insbesondere durch Bohren oder Stanzen in dem Pastenträger hergestellt werden. Gemäß einem anderen Herstellungsverfahren, insbesondere für einen bandförmigen Pastenträger, können die Positionen der Pastenkammern auf einer durchgehenden Trägerfläche in einer Photomaske freigelegt sein und die Pastenkammern durch ein Ätzmittel an den freigelegten Stellen erzeugt werden. Bei einer sich dabei evtl. ergebenden Aufweitung der Pastenkammern nach einer Seite des Pastenträgers ist die größere Öffnung vorzugsweise dem Druckkopf zugewandt, wobei ein konischer Wandungsverlauf der Pastenkammern u. U. ein Eintauchen der Drucknadeln erleichtern kann. Der Querschnitt des ausgestoßenen Pastenvolumens bleibt durch die der Leiterplatte zugewandte engere Öffnung bzw. durch die Drucknadelstirnfläche bestimmt.

Die Oberfläche der Drucknadeln ist vorteilhafterweise nicht durch die Lotpaste benetzend ausgeführt, wogegen die Lotpaste vorzugsweise die Leiterplattenoberfläche oder zumindest die mit Lotpaste zu versehenden Stellen benetzend ist.

Das Befüllen der Pastenkammer erfolgt durch eine Befülleinheit BE, welche im skizzierten Beispiel in geringer Entfernung vor dem Transferbereich TB angeordnet ist, sich aber auch an anderer Position am ringförmigen Pastenträger befinden kann. Das Einbringen von Lotpaste in leere Pastenkammern kann beispielsweise durch Einstreichen von im Überschuß auf den Pastenträger aufgebrachter Lotpaste in die Pastenkammer mit einer Rakel oder dergleichen von einer oder beiden Seiten des Trägers erfolgen. Lotpastenüberstände können durch Klingen von dem Träger abgenommen werden. Der Befülleinheit wird über eine Versorgungsleitung Lötpaste aus einem Depot DE nachgeführt.

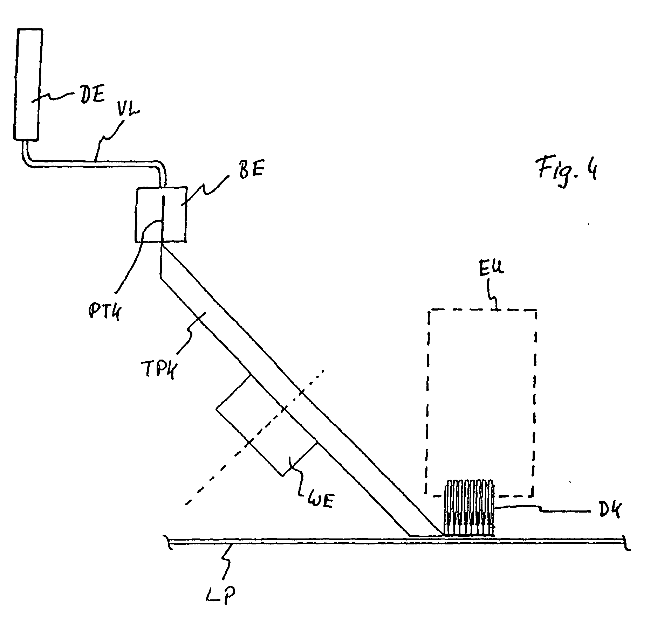

Die Fig. 4 zeigt in einer geschnittenen Seitenansicht eine Ausführungsform, bei welcher ein Pastenträger PTK als Kegelstumpfmantel in Fortsetzung einer kegelstumpfförmigen Trägerplatte TPK ausgeführt ist. Die Kegelachse TAK, um welche Trägerplatte und Pastenträger drehbar sind, ist so gegen die Ebene der Leiterplatte geneigt, daß die Kegelmantellinie im Transferbereich TB parallel zur Leiterplatte verläuft. Diese Ausführung bietet mehr Freiraum für die Anordnung der Betätigungseinrichtung oberhalb des Druckkopfes.

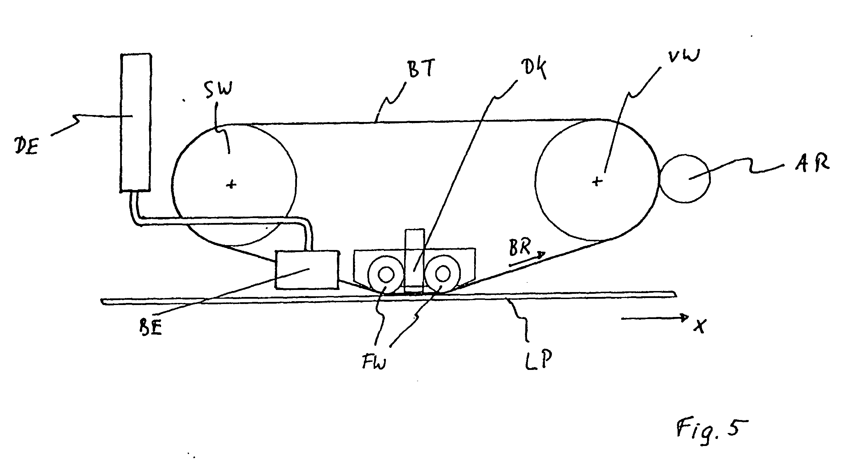

Bei der in Fig. 5 skizzierten Vorrichtung ist der Pastenträger ein flexibles Endlosband BT, welches im Transferbereich durch in Bewegungsrichtung BR vor und nach dem Druckkopf DK angeordnete Führungswalzen FW umgelenkt und seitlich (Y) und vertikal präzis geführt ist. Der Transport des Bandes in Bewegungsrichtung BR relativ zum Druckkopf erfolgt durch eine Vorschubwalze, an welche das Endlosband durch eine Andruckrolle AR angedrückt sein kann. Durch eine Spannwalze SW wird das Endlosband erneut umgelenkt und straff gehalten. Eine Befülleinrichtung BE ist wieder in Bewegungsrichtung BR kurz vor dem Transferbereich TB vorgesehen.

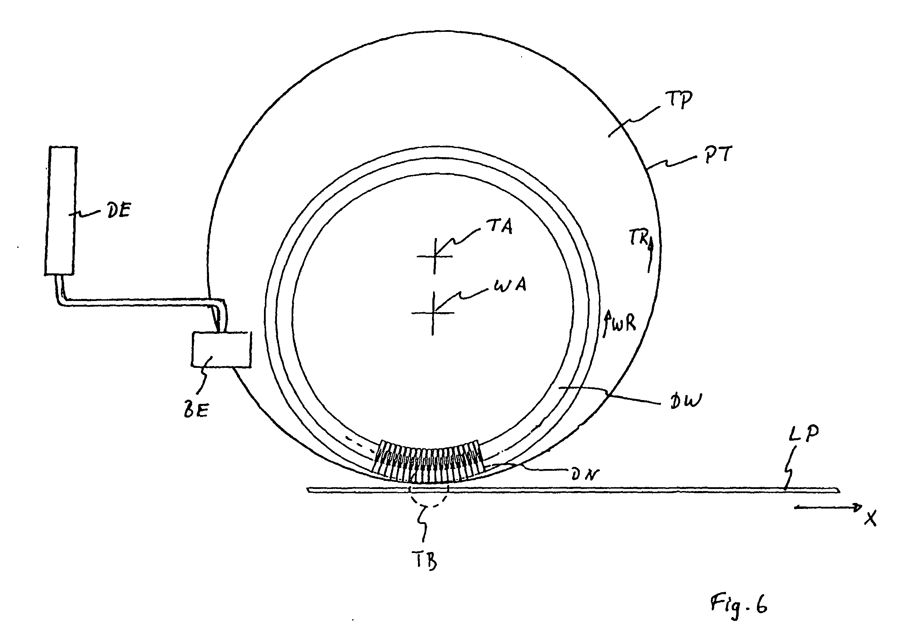

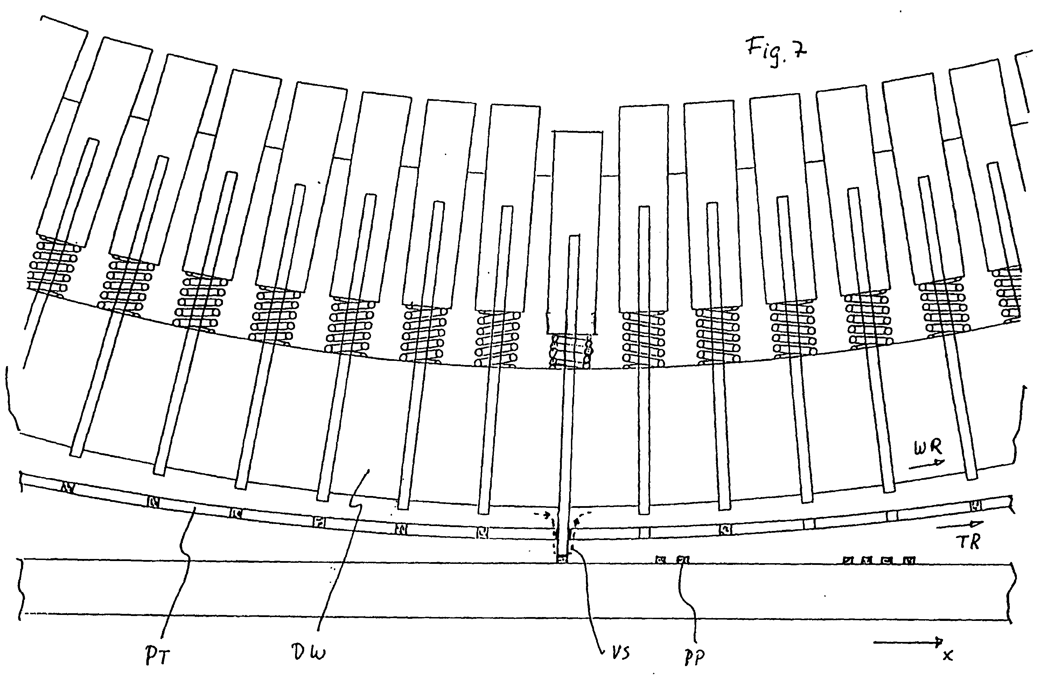

Die in Fig. 6 skizzierte Vorrichtung unterscheidet sich von der in Fig. 1 dargestellten im wesentlichen dadurch, daß nicht ein feststehender Druckkopf vorgesehen ist, sondern eine Druckwalze mit einer größeren Anzahl von über ihren Umfang verteilten Reihen von Drucknadeln innerhalb des ringförmigen Pastenträgers PT angeordnet und um eine zur Trägerachse TA des Pastenträgers parallele Walzenachse drehbar ist. Die Walzenachse WA liegt zwischen Trägerachse TA und dem in Fig. 7 vergrößert dargestellten Transferbereich, in welchem der Abstand zwischen Außenumfang der Druckwalze und Innenwand des Pastenträgers minimal ist. Die Druckwalze und der Pastenträger sind gleichsinnig um ihre jeweiligen Achsen gedreht und zeigen im Transferbereich gleiche Umfangsgeschwindigkeiten, so daß im Transferbereich auch ohne Anhalten der Drehbewegungen für einen Übertragungsvorgang eine konstante Winkellage von Drucknadel und Pastenkammern gegeben ist. Die Nadelreihen können wiederum alternierend in Y-Richtung gegeneinander versetzt sein. Vorzugsweise ist eine für alle Nadelreihen der Druckwalze gemeinsame Betätigungseinrichtung vorgesehen, welche jeweils eine oder mehrere im Transferbereich TB befindliche Nadelreihen beaufschlagen kann. Anstelle der Druckwalzenform kann auch ein anderer Nadelreihenträger mit zylischem Transport einer geschlossenen Kette von Nadelreihen vorgesehen sein, welche im Transferbereich parallel und gleichförmig zu dem Pastenträger geführt ist. In Fig.7 ist mit VS der Verlauf der Stirnfläche einer verschobenen Drucknadel bei kontinuierlicher Weiterdrehung von Pastenträger und Druckwalze bezeichnet.

In der Vorrichtung nach Fig.8 ist das vorstehend geschilderte Prinzip der mit dem kontinuierlich bewegten Pastenträger im Transferbereich gleichförmig mit bewegten Nadelreihen übertragen auf einen bandförmigen Pastenträger, wobei das Band dabei auf dem walzenförmigen Träger der Nadelreihen aufliegen kann, wenn die Drucknadeln in ihrer Ausgangsposition nicht wie in Fig. 7 über die Walzenfläche hinausstehen, sondern vorzugsweise hinter diese zurückrücken.

Die Vorrichtung nach Fig. 8 zeigt ferner eine weitere vorteilhafte Variante eines Pastenträgers, welcher hier nicht als Endlosband, sondern als Bandwickel von einer Vorratsrolle BW abgewickelt wird und von einer Vorschubwalze transportiert wird. Die Pastenkammern in dem bandförmigen Pastenträger können auf dem Bandwickel leer sein und vor dem Transferbereich in der beschriebenen Weise mittels einer Befülleinheit mit Lotpaste gefüllt werden. Die Vorratsrolle kann aber auch das Band mit bereits gefüllten Pastenkammern enthalten, wodurch die Befülleinrichtung entfallen kann. Die Einfügung einer Trennfolie zwischen die Wicklungen des Bandes ist hierbei sinnvoll. Das Band wird beim Durchlauf durch die Rolle verbraucht und kann nach Wiederbefüllen oder Leeren der Pastenkammern erneut eingesetzt werden. Ein endliches Band von einer Vorratsrolle kann selbstverständlich auch in Verbindung mit einer Bandführung durch Führungsrollen wie in Fig. 5 benutzt werden.

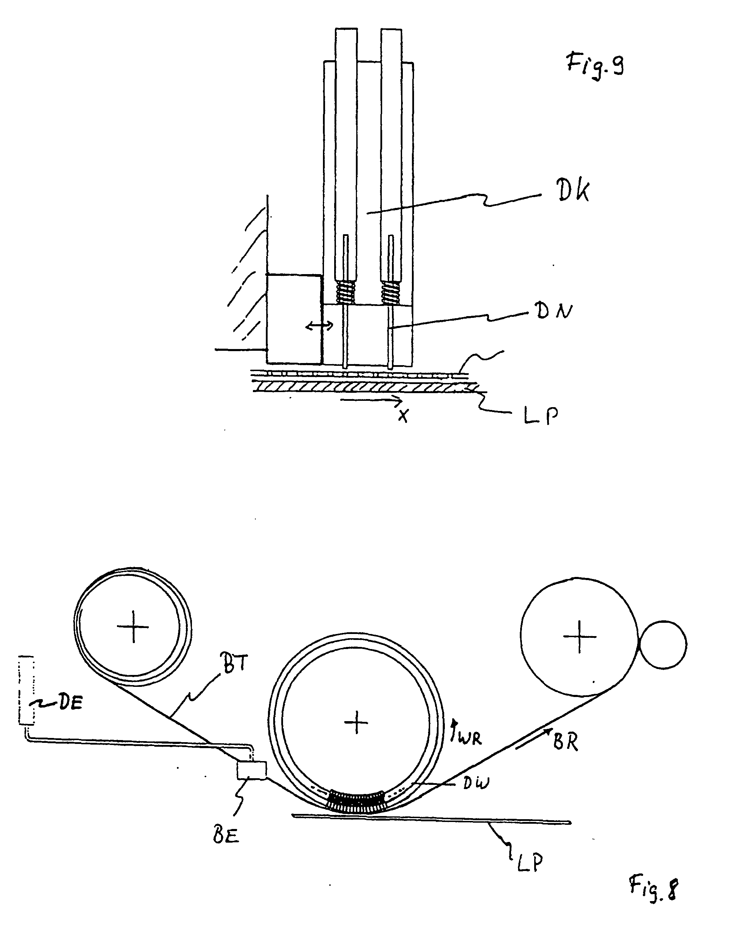

Die Fig. 9 zeigt eine Ausführung eines Druckkopfes, welcher parallel zur Bewegungsrichtung BR des Pastenträgers über einen begrenzten Bereich oszillierend ausgelenkt werden kann. Durch die oszillierende Bewegung mit einer ersten, zur Bewegung des Pastenträgers gleichsinnigen und einer zweiten, dazu gegensinnigen Bewegungsphase, kann der Pastenträger kontinuierlich bewegt und ein Übertragungsvorgang in der ersten Bewegungsphase des oszillierenden Druckkopfes, in der die Nadelreihen des Druckkopfs gleichförmig mit den Pastenkammern des Pastenträgers mitlaufen, ausgeführt werden. Nach Beendigung des Übertragungsvorgangs und Rücksetzen der Drucknadeln in ihre abgehobene Ausgangsposition kann der Druckkopf in seiner zweiten Bewegungsphase unabhängig von Pastenträger und gegenläufig zu dessen Bewegung zurückschwenken. Die oszillierende Auslenkung des Druckkopfs kann über einen mechanischen Antrieb oder bei kleinen Auslenkungsamplituden über eine elektrisch steuerbare Kontraktion und/oder Expansion eines Auslenkelementes AE, beispielsweise nach dem piezoelektrischen Effekt gegen einen feststehenden Halter vorgenommen werden.

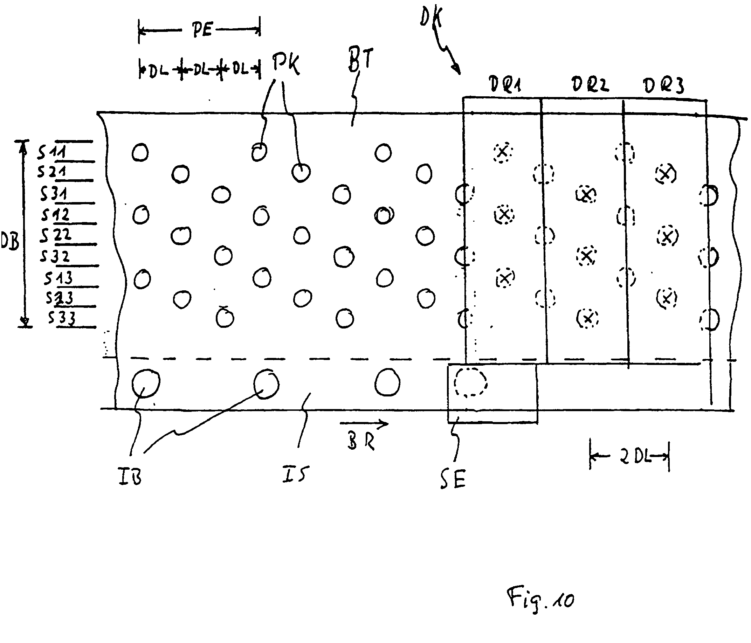

Bei der Draufsicht auf einen Pastenträger, insbesondere einen bandförmigen Pastenträger BT nach Fig. 10 ist ein Druckkopf mit drei in Bewegungsrichtung BR des Pastenträgers PT nacheinander angeordneten Nadelreihen DR1, DR2 und DR3 vorgesehen, wobei jede der Nadelreihen drei senkrecht zur Bewegungsrichtung BR gleich beabstandete Nadeln an den durch Kreuze markierten Positionen aufweist. Der Pastenträger PT ist beispielsweise bandförmig und weist innerhalb der Breite des Bandes einen Teilbereich der Breite DB auf, welcher durch mehrere Zeilen Sij von Pastenkammern im wesentlichen vollständig durch die Pastenkammern abgedeckt ist. Die Anzahl der Zeilen in Längsrichtung des bandförmigen Pastenträgers beträgt im skizzierten Beispielsfall neun. Die Positionen der Nadeln in den einzelnen Nadelreihen DR1, DR2 und DR3 des Druckkopfes DK sind derart auf die mehreren Zeilen des Pastenkammern-Musters auf dem Pastenträger so verteilt, daß die Nadeln der Nadelreihe DR1 über den Zeilen S11, S12 und S13, die Nadeln der Nadelreihe DR2 über den Zeilen S31, S32 und S33 und die Nadeln der Nadelreihe DR3 über den Zeilen S21, S22 und S23 liegen. Die Nadelreihen seien in Bewegungsrichtung BR des Pastenträgers um eine Distanz 2 DL versetzt.

Die Pastenkammern PK in dem Pastenträger PT sind regelmäßig in der Weise angeordnet, daß innerhalb einer in Bewegungsrichtung BR und Längsrichtung des Pastenträgers liegende Pastenkammern um eine Periodenlänge PE beabstandet sind und die Pastenkammern zugleich senkrecht zur Bewegungsrichtung BR in Reihen mit gleichen Abständen zueinander quer zur Bewegungsrichtung liegen. Innerhalb einer Reihe von Pastenkammern liegen jeweils Pastenkammern in den Zeilen S11, S12 und S13 bzw. in den Zeilen S21, S22 und S23 bzw. S31, S32 und S33 auf gleicher Position in Bewegungsrichtung BR und die in Bewegungsrichtung BR aufeinanderfolgenden, quer dazu gegeneinander versetzten Reihen von Pastenkammern sind um eine gleichmäßige Distanz voneinander beabstandet. Bei gleichmäßiger periodischer Fortsetzung des Musters ergibt sich dabei eine Periodenlänge PE gleich 3 DL. Bei der vorstehend angegebenen Verteilung der Nadeln in den drei Nadelreihen DR1, DR2 und DR3 über den einzelnen Zeilen ist für den Abstand der Nadelreihen in Bewegungsrichtung BR ein Wert von 2 DL besonders vorteilhaft, da dann in Verschiebungsschritten PE des Pastenträgers PT jeweils alle Nadeln des Druckkopfes über einer Pastenkammer liegen. Die skizzierte Verteilung von Pastenkammern auf einem Pastenträger und Nadeln innerhalb eines Druckkopfes ist lediglich als eine von vielen Möglichkeiten der Anschaulichkeit halber gegeben.

Auf einem zusätzlichen Indexstreifen IS des bandförmigen Pastenträgers PT sind Indexbohrungen IB angebracht, welche von einem Sensor SE, welcher vorzugsweise fest mit der Position des Druckkopfes DK verbunden ist, detektiert werden, so daß zuverlässig die Pastenträgerpositionen bzw. die Zeitpunkte ermittelbar sind, zu welchen die Nadeln des Druckkopfes über Pastenkammern liegen und ein Übertragungsvorgang unter Beteiligung einer oder mehrerer Nadeln ausgelöst werden kann.

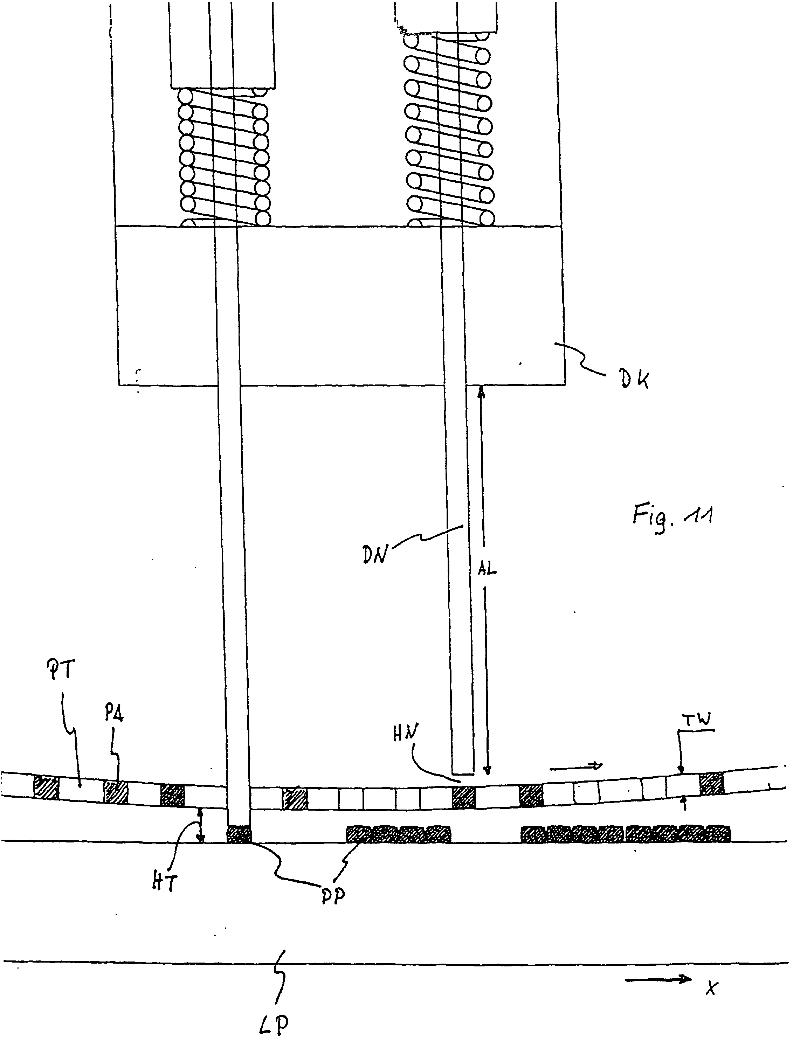

Die in Fig. 11 skizzierte Ausführung einer Transfereinrichtung entspricht weitgehend der in Fig. 3 skizzierten Anordnung, die Drucknadeln DN verlaufen hier aber über einen langen Abschnitt AL, welcher wenigstens das 5-fache der Wandstärke TW des Pastenträgers PT beträgt, frei außerhalb der Führung im Druckkopf DK. Die Drucknadeln DN besitzen dadurch eine gegenüber der Anordnung nach Fig. 3 erweiterte seitliche Beweglichkeit, wodurch die Gefahr, daß sich eine Drucknadel in einer Pastenkammer verkantet, erheblich vermindert wird.

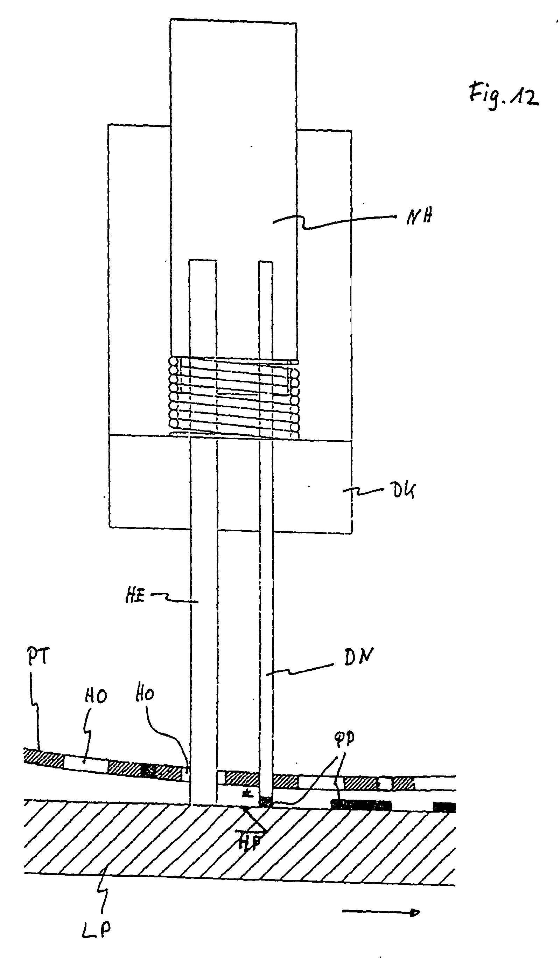

In Fig. 12 ist eine Ausführungsform skizziert, bei welcher ein Hilfselement HE gemeinsam und gleichsinnig mit einer Drucknadel DN verschoben wird. Das Hilfselement ist hierfür beispielsweise in einem Nadelhalter NH im Druckkopf oder auf andere Weise fest an die Verschiebung der Drucknadel gekoppelt. Das Hilfselement ragt um das Maß HP, welches im wesentlichen der Dicke der Lotpastenpunkte PP entspricht, weiter in Richtung zur Leiterplatte LP als die Drucknadel selbst. Das Hilfselement taucht durch Hilfsöffnungen HO im Pastenträger hindurch und begrenzt durch den Anschlag an die Leiterplatte die Verschiebung, so daß auch bei Unebenheiten der Leiterplatte eine konstante Dicke der Lotpastenpunkte PP gewährleistet ist.

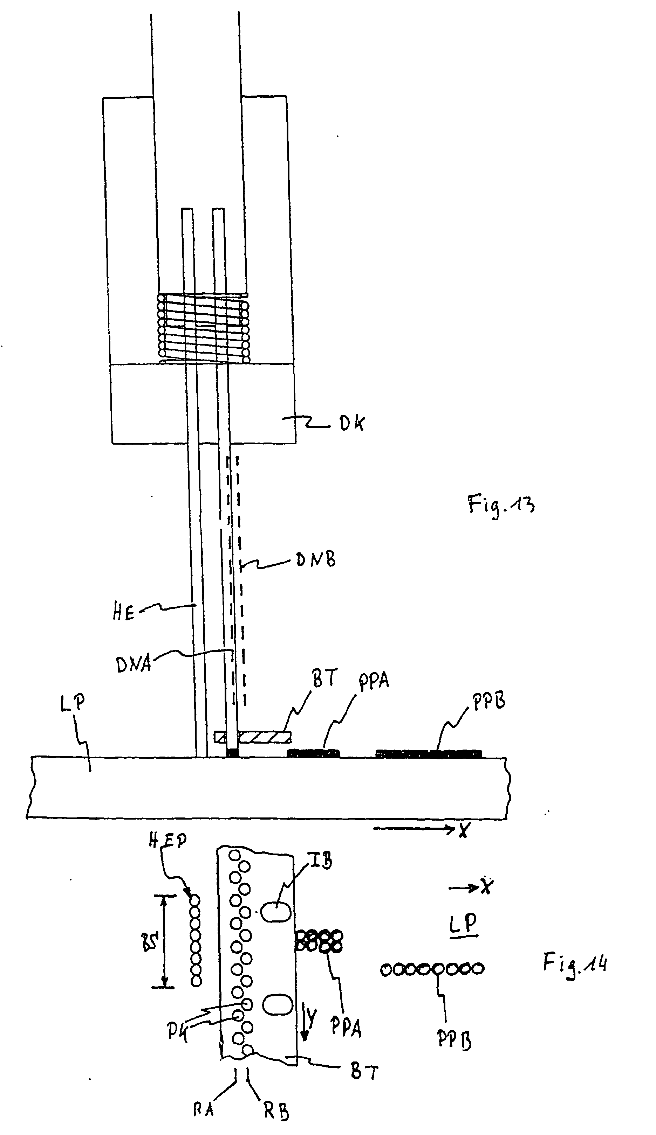

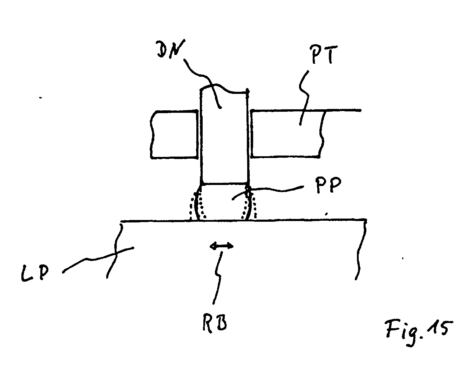

Bei der in Fig. 13 skizzierten Anordnung ist wiederum das Prinzip der Endlagenbegrenzung durch Anschlag eines mit einer Drucknadel verschobenen und auf der Leiterplatte LP anschlagenden Hilfselements HE dargestellt, wobei das Hilfselement aber nicht durch eine zusätzlich Öffnung im Pastenträger BT, sondern neben dem Pastenträger verläuft. Bei einem Druckkopf DK mit einer Nadelreihe verläuft die Nadelreihe dann in Abweichung von den vorhergehenden Beispielen in Bewegungsrichtung des Pastenträgers. Im skizzierten Beispiel ist der bandförmige Pastenträger BT senkrecht zur Zeichenebene der Fig. 13 relativ zum Druckkopf bewegbar (Y-Richtung in Fig. 14) und der Druckkopf enthält zwei in X-Richtung gegeneinander versetzte Nadelreihen mit Drucknadeln DNA bzw. DNB, letztere in Fig. 13 mit unterbrochener Linie angedeutet.

Wie aus der Draufsicht auf den Pastenträger BT und die Leiterplatte LP in Fig. 14 ersichtlich, weist der Pastenträger in seiner Bewegungsrichtung Y zwei Reihen RA, RB von Pastenkammern auf, welche in X-Richtung gering gegeneinander versetzt sind und deren Pastenkammern in Y-Richtung gegenseitig auf Lücke angeordnet sind. Die beiden Drucknadelreihen decken in Y-Richtung gemeinsam im wesentlichen lückenlos einen Bereich der Länge BS ab. Die Positionen der Hilfselemente HE sind in Fig. 14 mit HEP bezeichnet.

Vorzugsweise wird die Leiterplatte LP relativ zum Druckkopf in X-Richtung verschoben, wobei sowohl Leiterplatte als auch Druckkopf verschiebbar sein können. Bei dieser Verschiebung überstreichen die Nadelreihen des Druckkopfes einen Streifen der Breite.BS über der Leiterplatte. Durch aufeinanderfolgendes Überstreichen paralleler und in Y-Richtung nebeneinander liegender solcher Streifen kann die gesamte Leiterplattenfläche bearbeitet werden.

Der Pastenträger BT kann von Übertragungsvorgang zu Übertragungsvorgang um gleiche Schrittweiten in Y-Richtung relativ zum Druckkopf bewegt werden, wobei die Schrittweiten vorzugsweise gleich der Länge BS sind. Als Ausrichthilfen können wieder Indexbohrungen IB oder andere Markierungen auf dem Pastenträger im Abstand der Schrittweite vorgesehen sein. Die Vorschubbewegung des Pastenträgers zwischen zwei Übertragungsvorgängen kann aber auch in kleineren Schritten der Periodenlänge der regelmäßig in Y-Richtung aufeinanderfolgenden Pastenkammem vorgenommen werden, wenn durch Auswertung der für die Übertragungsvorgänge in den einzelnen Vorschubschritten ausgewählten Pastenkammer in einer Steuereinrichtung vermieden werden kann, daß eine Drucknadel über einer bereits zuvor geleerten Pastenkammer betätigt wird. Mit PPA und PPB sind zwei auf der Leiterplatte erzeugte Punktgruppen bezeichnet.

Gemäß einer in Fig. 15 skizzierten vorteilhaften Weiterbildung kann während des Andrucks des ausgestossenen Lotpastenpunkts PP auf die Leiterplatte eine zusätzliche, insbesondere oszillierende Relativbewegung RB von Druckkopf bzw. Transferelement einerseits und Leiterplatte andererseits in der Leiterplattenebene vorgesehen sein, deren Amplitude klein ist gegen den Durchmesser der Pastenkammer bzw. den Durchmesser des Pastenkörpers. In Fig. 15 ist eine solche zusätzliche Relativbewegung als Bewegung der Leiterplatte bei feststehendem Druckkopf skizziert. Die zusätzliche Relativbewegung, die vorzugsweise in zwei orthogonalen Richtungen in der Leiterplattenebene erfolgt, kann auch durch eine Bewegung des Druckkopfes oder durch Bewegung von Druckkopf und Leiterplatte, z. B. in unterschiedlichen Richtungen erfolgen.

Die vorstehend und die in den Patentansprüchen angegebenen Merkmale sind sowohl einzeln als auch in verschiedener Kombination vorteilhaft realisierbar. Die Erfindung ist nicht auf die beschriebenen Ausführungsbeispiele beschränkt, sondern im Rahmen fachmännischen Könnens in mancherlei Weise abwandelbar.

## Patentansprüche

1. Vorrichtung zum Aufbringen von Lotpaste auf eine Leiterplatte (LP) mittels einer Transfereinrichtung (TE), welche einen Pastenträger (PT) und einen Druckkopf (DK) umfasst, mit den Merkmalen
a) der Pastenträger (PT) weist eine Mehrzahl von mit Lotpaste (PA) gefüllten Pastenkammern (PK) auf,
b) der Druckkopf (DK) kann mittels wenigstens eines Transferelements (DN) Lotpaste aus auswählbaren Pastenkammem auf die Leiterplatte (LP) übertragen,
c) der Pastenträger (PT) ist relativ zum Druckkopf (DK) bewegbar und die Zahl der Transferelemente ist kleiner als 5% der Zahl der Pastenkammern,
d) die Transfereinrichtung ist relativ zu der Leiterplatte verfahrbar,
e) die Transfereinrichtung kann durch eine Mehrzahl zeitlich aufeinander folgender Übertragungsvorgänge ein vorgebbares Pastenmuster auf der Leiterplatte erzeugen.

2. Vorrichtung nach Anspruch 1, **dadurch gekennzeichnet, dass** das Transferelement senkrecht zur Leiterplatte durch die Pastenkammer verschiebbar ist.

3. Vorrichtung nach Anspruch 2, **dadurch gekennzeichnet, daß** das Transferelement einen der Leiterplatte zugewandten drahtförmigen Abschnitt besitzt.

4. Vorrichtung nach Anspruch 2 oder 3, **dadurch gekennzeichnet, dass** die Zahl der Transferelements des Druckkopfs kleiner als 1 % der Zahl der Pastenkammern ist.

5. Vorrichtung nach Anspruch 4, **dadurch gekennzeichnet, daß** mehrere Transferelemente in wenigstens einer quer zur Bewegungsrichtung des Pastenträgers verlaufenden Reihe angeordnet sind.

6. Vorrichtung nach Anspruch 4 oder 5, **dadurch gekennzeichnet, daß** die Bewegung des Pastenträgers schrittweise erfolgt und für einen Übertragungsvorgang unterbrochen ist.

7. Vorrichtung nach Anspruch 4 oder 5, **dadurch gekennzeichnet, daß** die Bewegung des Pastenträgers kontinuierlich erfolgt und die dem Pastenträger zugewandten Enden der Transferelemente zumindest während des Obertragungsvorgang in Bewegungsrichtung gleichförmig mit dem Pastenträger mitlaufen.

8. Vorrichtung nach einem der Ansprüche 1 bis 7, **dadurch gekennzeichnet, daß** der Pastenträger als um eine Drehachse kreissymmetrischer Ringmantel von einer Trägerscheibe absteht.

9. Vorrichtung nach einem der Ansprüche 1 bis 8, **gekennzeichnet durch** eine Füllvorrichtung zur Befüllung von leeren Pastenkammern.

10. Vorrichtung nach einem der Ansprüche 1 bis 9, **dadurch gekennzeichnet, daß** Mittel zur Ausführung einer zusätzlichen Relativbewegung von Transfereinrichtung und Leiterplatte in der Leiterplattenebene mit gegen den Durchmesser einer Pastenkammer kleiner Amplitude vorgesehen sind.

## Claims

1. Apparatus for applying solder paste to a printed circuit board (LP) by means of a transfer device (TE) which comprises a paste carrier (PT) and a pressure head (DK), having the features
a) the paste carrier (PT) has a plurality of paste chambers (PK) filled with solder paste (PA),
b) the pressure head (DK) can transfer solder paste from selectable paste chambers to the printed circuit board (LP) by means of at least one transfer element (DN),
c) the paste carrier (PT) is movable relative to the pressure head (DK), and the number of transfer elements is less than 5% of the number of paste chambers,
d) the transfer device is movable relative to the printed circuit board,
e) the transfer device can produce a predeterminable paste pattern on the printed circuit board by a plurality of successive transfer operations.

2. Apparatus according to Claim 1, **characterized in that** the transfer element is displaceable through the paste chamber perpendicularly to the printed circuit board.

3. Apparatus according to Claim 2, **characterized in that** the transfer element has a wire-shaped section facing the printed circuit board.

4. Apparatus according to Claim 2 or 3, **characterized in that** the number of transfer elements of the pressure head is less than 1% of the number of paste chambers.

5. Apparatus according to Claim 4, **characterized in that** a plurality of transfer elements are arranged in at least one row running transversely to the direction of movement of the paste carrier.

6. Apparatus according to Claim 4 or 5, **characterized in that** the movement of the paste carrier is effected progressively and is interrupted for a transfer operation.

7. Apparatus according to Claim 4 or 5, **characterized in that** the movement of the paste carrier is effected continuously, and those ends of the transfer elements which face the paste carrier run uniformly with the paste carrier in the direction of movement at least during the transfer operation.

8. Apparatus according to one of Claims 1 to 7, **characterized in that** the paste carrier projects from a carrier disc as an annular shell which is circular symmetric about an axis of rotation.

9. Apparatus according to one of Claims 1 to 8, **characterized by** a filling device for filling empty paste chambers.

10. Apparatus according to one of Claims 1 to 9, **characterized in that** means are provided for performing an additional relative movement of transfer device and printed circuit board in the printed-circuit-board plane with a small amplitude relative to the diameter of a paste chamber.

## Revendications

1. Appareil pour la déposition de pâte à souder sur une plaquette de circuit imprimé (LP) au moyen d'un dispositif de transfert (TE) qui comprend un support de pâte (PT) et une tête d'impression (DK), ayant les caractéristiques suivantes :
a) le support de pâte (PT) présente une pluralité de chambres de pâte (PK) remplies de pâte à souder (PA),
b) la tête d'impression (DK) peut transférer au moyen d'au moins un élément de transfert (DN) de la pâte à souder de chambres de pâte sélectionnables à la plaquette de circuit imprimé (LP),
c) le support de pâte (PT) peut être déplacé par rapport à la tête d'impression (DK) et le nombre des éléments de transfert est inférieur à 5% du nombre des chambres de pâte,
d) le dispositif de transfert peut être déplacé par rapport à la plaquette de circuit imprimé,
e) le dispositif de transfert peut produire, par une pluralité d'opérations de transfert successives, un modèle de pâte prédéfinissable sur la plaquette de circuit imprimé.

2. Appareil selon la revendication 1, **caractérisé en ce que** l'élément de transfert peut être déplacé perpendiculairement à la plaquette de circuit imprimé à travers les chambres de pâte.

3. Appareil selon la revendication 2, **caractérisé en ce que** l'élément de transfert possède une portion en forme de fil tournée vers la plaquette de circuit imprimé.

4. Appareil selon la revendication 2 ou 3, **caractérisé en ce que** le nombre des éléments de transfert de la tête d'impression est inférieur à 1% du nombre des chambres de pâte.

5. Appareil selon la revendication 4, **caractérisé en ce que** plusieurs éléments de transfert sont disposés dans au moins une rangée s'étendant transversalement à la direction de déplacement du support de pâte.

6. Appareil selon la revendication 4 ou 5, **caractérisé en ce que** le déplacement du support de pâte s'effectue par incréments et est interrompu pour une opération de transfert.

7. Appareil selon la revendication 4 ou 5, **caractérisé en ce que** le déplacement du support de pâte s'effectue en continu et les extrémités des éléments de transfert tournées vers le support de pâte avancent uniformément avec le support de pâte au moins pendant l'opération de transfert dans la direction de déplacement.

8. Appareil selon l'une quelconque des revendications 1 à 7, **caractérisé en ce que** le support de pâte dépasse d'un disque de support sous forme d'une enveloppe annulaire à symétrie de révolution autour d'un axe de rotation.

9. Appareil selon l'une quelconque des revendications 1 à 8, **caractérisé par** un dispositif de remplissage pour le remplissage de chambres de pâte vides.

10. Appareil selon l'une quelconque des revendications 1 à 9, **caractérisé en ce que** l'on prévoit des moyens pour réaliser un déplacement relatif supplémentaire du dispositif de transfert et de la plaquette de circuit imprimé dans le plan de la plaquette de circuit imprimé avec une petite amplitude par rapport au diamètre d'une chambre de pâte.
